# EUROPÄISCHE PATENTANMELDUNG

(11) **EP 3 702 859 A1**
(43) Veröffentlichungstag der Anmeldung: **02.09.2020**
(21) Anmeldenummer: 20159733.3
(22) Anmeldetag: 27.02.2020
(51) Int. Cl.: G05B 19/418, G06F 30/18, G06F 30/20

(54) **VERFAHREN ZUR ANLAGENAUSLEGUNG EINES ELEKTRISCHEN AUTOMATISIERUNGSSYSTEMS**

(30) Priorität: 27.02.2019 DE 102019104987
(71) Anmelder: Phoenix Contact GmbH & Co. KG, 32825 Blomberg (DE)
(72) Erfinder: BURY, Joachim, 92224 Amberg (DE); RIES, Stefan, 92648 Vohenstrauß (DE); SCHMIDT, Hans-Peter, 91242 Ottensoos (DE)
(74) Vertreter: Maiwald Patent- und Rechtsanwaltsgesellschaft mbH

(57) **Zusammenfassung**

Die vorliegende Erfindung betrifft ein Verfahren zur Anlagenauslegung eines elektrischen Automatisierungssystems, wobei das Verfahren folgende Verfahrensschritte aufweist: Bereitstellen (S1) eines Anlagenlayouts des Automatisierungssystems mit einer dem bereitgestellten Anlagenlayout zugeordneten Last- und Energieverteilung für eine Verkabelung des Automatisierungssystems; Generieren (S2) von Kenngrößen für die zugeordnete Last- und Energieverteilung des Automatisierungssystems; Durchführen (S3) eines Systemtestes für das bereitgestellte Anlagenlayout des Automatisierungssystems basierend auf den generierten Kenngrößen; und Optimieren (S4) des Anlagenlayouts basierend auf einem Ergebnis des Systemtests und den generierten Kenngrößen.

## Beschreibung

### Technisches Gebiet

Die vorliegende Erfindung betrifft Systeme für die Projektierung von elektrischen Versorgungs-, Daten- oder Steuernetzen.

Insbesondere betrifft die vorliegende Erfindung eine Vorrichtung und ein Verfahren zur Anlagenauslegung eines elektrischen Automatisierungssystems.

### Technischer Hintergrund

Der Aufbau von elektrischen Netzen - etwa Versorgungs-, Daten- oder Steuernetze - kann komplexe Strukturen mit aktiven oder passiven elektrischen Knoten, sowie integrierten Funktionskomponenten und Steuerungskomponenten bilden.

Der so gebildete Automatisierungs-Verbund kann ein beliebig tiefes und beliebig komplex verflochtenes Netz bilden, welches beispielsweise nur in aufwändiger Weise nach Kirchhoff berechnet werden kann.

### Zusammenfassung der Erfindung

Es ist eine Aufgabe der vorliegenden Erfindung, eine verbesserte Vorrichtung und ein verbessertes Verfahren zur Anlagenauslegung eines elektrischen Automatisierungssystems bereitzustellen.

Diese Aufgabe wird durch die Gegenstände der unabhängigen Patentansprüche gelöst. Weiterbildungen und Ausführungsformen sind den abhängigen Patentansprüchen, der Beschreibung und den Figuren der Zeichnungen zu entnehmen.

Ein erster Aspekt der vorliegenden Erfindung betrifft ein Verfahren zur Anlagenauslegung eines elektrischen Automatisierungssystems, wobei das Verfahren folgende Verfahrensschritte umfasst.

Als ein erster Verfahrensschritt erfolgt ein Bereitstellen eines Anlagenlayouts des Automatisierungssystems mit einer zugeordneten Last- und Energieverteilung für eine Verkabelung des Automatisierungssystems.

Als ein zweiter Verfahrensschritt erfolgt ein Generieren von Kenngrößen für die zugeordnete Last- und Energieverteilung des Automatisierungssystems.

Als ein dritter Verfahrensschritt erfolgt ein Durchführen eines Systemtestes für das bereitgestellte Anlagenlayout des Automatisierungssystems basierend auf den generierten Kenngrößen.

Als ein vierter Verfahrensschritt erfolgt ein Optimieren des Anlagenlayouts basierend auf einem Ergebnis des Systemtests und basierend auf den generierten Kenngrößen.

Das elektrische Automatisierungssystem enthält dabei ein elektrisches Netzwerk, welches als ein Versorgungs-, Daten- oder Steuernetzwerk ausgebildet sein kann oder aus einer Kombination der genannten Netzwerktypen.

Die vorliegende Erfindung ermöglicht, die Projektierung von elektrischen Netzen für beispielsweise Nieder- und Kleinspannungsnetzwerke durch eine abgeschlossene funktionale Einheit in Form einer Software bzw. eines Softwaremoduls.

Ferner ermöglicht die vorliegende Erfindung vorteilhaft, eine Benutzer-unterstützende und Vorgaben-geleitete grafische Erstellung von elektrischen Netzwerken in Linien-, Baum- und Ringstrukturen, unter Verwendung von modularen und anpassbaren Knoten-Bausteinen, Verzweigungen und Komponenten des Systems.

Die vorliegende Erfindung ermöglicht, die Berechnung von Kurzschlussströmen, Spannungsfällen an den Knoten des Netzwerks sowie von Lastverteilungen und Ausfallwahrscheinlichkeiten durchzuführen und Überlastszenarien für das Automatisierungssystem zu simulieren bzw. vorherzusagen.

Die vorliegende Erfindung ermöglicht, dass in adaptierter und vollautomatisch angepasster Weise ein flexibler Versorgungsnetz-Aufbau des Anlagenlayouts des Automatisierungssystems simuliert werden kann.

Die folgenden Vorteile der vorliegenden Erfindung gewährleisten einen Mehrwert bzw. eine Alleinstellung des der vorliegenden Erfindung zugrundeliegenden Projektierungstools:
Die vorliegende Erfindung ermöglicht die Planung der Last- und/oder Energieverteilung des Automatisierungssystems durch eine vollautomatisierte visuelle Ausgabe und Darstellung des Anlagenlayouts des Automatisierungssystems.

Die vorliegende Erfindung ermöglicht ferner eine vollautomatisierte Bewertung der Sicherheitsreserven des Versorgungsnetz-Aufbaus des Automatisierungssystems durch die Variation geeigneter Projekt-Parameter, um die Eignung und die Grenzen des Modells für die Realität zu testen. Die Variation geeigneter Projekt-Parameter kann dabei innerhalb vordefinierter Variationsbereiche erfolgen, um die Projekt-Parameter optimieren zu können.

Eine Generierung von Kenngrößen für die Energie- und Stromlastverteilungen im Anlagenlayout des Automatisierungssystems wird ebenso beispielsweise vorteilhaft durch die vorliegende Erfindung ermöglicht.

Die dabei verwendeten Kenngrößen erlauben eine Bewertung und den Vergleich unterschiedlicher Aufbauformen des Anlagenlayout, welchen jeweils vorbestimmte Kenngrößen zugeordnet werden. Als die unterschiedlichen Aufbauformen des Anlagenlayout können etwa unterschiedliche Topologien eines elektrischen Netzes, Stern-Topologie gegen Ring-Topologie gegen Linien-Topologie gegen Baum-Topologie gegen vermaschtes Netz oder Zell-Topologie verwendet werden.

Die Überlaststandhaftigkeit der sechs hier beispielhaft genannten Topologien kann durch das Verfahren der vorliegenden Erfindung verglichen werden und die beste Topologie wird für den Aufbau gewählt.

Ferner kann beispielsweise eine Optimierung basierend auf einer quantitativen Ermittlung des Gesamtwirkungsgrads der Energieverteilung, der Über- oder Unterdimensionierung der Verkabelung im Anlagenlayout des Automatisierungssystems vorgenommen werden.

Vorteilhafte Ausgestaltungen der vorliegenden Erfindung sind den Unteransprüchen zu entnehmen.

In einer vorteilhaften Ausführungsform der vorliegenden Erfindung ist vorgesehen, dass der Systemtest für das bereitgestellte Anlagenlayout des Automatisierungssystems eine Variation von
i) Parametern des elektrischen Automatisierungssystems; und/oder
ii) den generierten Kenngrößen
umfasst.

In einer vorteilhaften Ausführungsform der vorliegenden Erfindung ist vorgesehen, dass das Optimieren des Anlagenlayouts basierend auf dem Ergebnis des Systemtests und den generierten Kenngrößen umfasst:
i) ein Vergleich einer Vielzahl von unterschiedlichen Aufbauformen von unterschiedlichen Anlagenlayouts; und/oder
ii) eine quantitative Ermittlung einer Über- und/oder Unter-Dimensionierung der Verkabelung des bereitgestellten Anlagenlayouts.

In einer vorteilhaften Ausführungsform der vorliegenden Erfindung ist vorgesehen, dass das Optimieren des Anlagenlayouts basierend auf dem Ergebnis des Systemtests und den generierten Kenngrößen umfasst:
i) ein Optimieren basierend auf einem Vergleich einer Vielzahl von unterschiedlichen Aufbauformen von unterschiedlichen Anlagenlayouts; und/oder
ii) ein Optimieren basierend auf einer quantitativen Ermittlung einer Über- und/oder Unter-Dimensionierung der Verkabelung des bereitgestellten Anlagenlayouts; und/oder
iii) ein Optimieren basierend auf einer quantitativen Ermittlung der Verlustleistungen und/oder des Wirkungsgrads der Verkabelung des bereitgestellten Anlagenlayouts.

In einer vorteilhaften Ausführungsform der vorliegenden Erfindung ist vorgesehen, dass basierend auf den generierten Kenngrößen für die zugeordnete Last- und Energieverteilung des Automatisierungssystems und auf dem Anlagenlayout eine dem Anlagenlayout zugeordnete Bewertung der Last- und Energieverteilung des Automatisierungssystems bereitgestellt wird.

In einer vorteilhaften Ausführungsform der vorliegenden Erfindung ist vorgesehen, dass die Verkabelung definiert wird durch Daten zu
i) Kabellängen von einem Kabel oder von mehreren Kabeln oder aller Kabel der Verkabelung; und/oder
ii) Leiterquerschnitte von einem Kabel oder von mehreren Kabeln oder aller Kabel der Verkabelung; und/oder
iii) einer Knotenstruktur von mehreren Kabeln oder aller Kabel der Verkabelung; und/oder
iv) einer Verlustleistung eines anteiligen Kabels der Verkabelung; und/oder
v) einem Wirkungsgrad eines anteiligen Kabels der Verkabelung; und/oder
vi) einer Verlustleistung von mehreren Kabeln oder aller Kabel der Verkabelung; und/oder
vii) einem Wirkungsgrad von mehreren Kabeln oder aller Kabel der Verkabelung;
eines Kabelnetzwerkes des elektrischen Automatisierungssystems.

In einer vorteilhaften Ausführungsform der vorliegenden Erfindung ist vorgesehen, dass der Systemtest für das bereitgestellte Anlagenlayout des Automatisierungssystems den Einfluss von Störungen wie
i) Spannungseinbruch; und/oder
ii) Lastwechsel; und/oder
iii) Ausfall einer Energieversorgung; und/oder
iv) Kurzschluss der Verkabelung; und/oder
v) Leitungsunterbrechung der Verkabelung
umfasst. Dies erhöht vorteilhaft die Ausfallsicherheit des Anlagenlayouts.

In einer vorteilhaften Ausführungsform der vorliegenden Erfindung ist vorgesehen, dass die Kenngrößen für die zugeordnete Last- und Energieverteilung des Automatisierungssystems
i) einen Wirkungsgrad einer oder mehrerer oder aller elektrischen Komponenten des Automatisierungssystems; und/oder
ii) eine Verlustleistung einer oder mehrerer oder aller Leitungen der Verkabelung des Automatisierungssystems; und/oder
iii) einen Materialanteil einer Leitung der Verkabelung des Automatisierungssystems; und/oder
iv) eine Materialmenge einer Leitung der Verkabelung des Automatisierungssystems; und/oder
v) eine Gewichtslast einer Leitung der Verkabelung des Automatisierungssystems
umfasst.

In einer vorteilhaften Ausführungsform der vorliegenden Erfindung ist vorgesehen, dass das Optimieren des Anlagenlayouts basierend auf dem Ergebnis des Systemtests und basierend auf den generierten Kenngrößen eine Berechnung von Leistungsreserven und/oder Überlastungszonen des Anlagenlayouts umfasst.

In einem zweiten Aspekt der vorliegenden Erfindung ist eine Vorrichtung zur Anlagenauslegung eines elektrischen Automatisierungssystems vorgesehen. Die Vorrichtung umfasst ein Konfigurationsmodul, ein Kenngrößenmodul, ein Systemtestmodul und ein Optimierungsmodul.

Das Konfigurationsmodul ist dazu ausgebildet, ein Anlagenlayout des Automatisierungssystems mit einer zugeordneten Last- und Energieverteilung für eine Verkabelung des Automatisierungssystems bereitzustellen.

Das Kenngrößenmodul ist dazu ausgebildet, Kenngrößen für die zugeordnete Last- und Energieverteilung des Automatisierungssystems zu generieren.

Das Systemtestmodul ist dazu ausgebildet, einen Systemtest für das bereitgestellte Anlagenlayout des Automatisierungssystems basierend auf den generierten Kenngrößen durchzuführen. Das Optimierungsmodul ist dazu ausgebildet, das Anlagenlayout basierend auf einem Ergebnis des Systemtests und den generierten Kenngrößen zu optimieren.

In einer vorteilhaften Ausführungsform der vorliegenden Erfindung ist vorgesehen, dass der Systemtest für das bereitgestellte Anlagenlayout des Automatisierungssystems eine Variation von
i) Parametern des elektrischen Automatisierungssystems; und/oder
ii) den generierten Kenngrößen
umfasst.

In einer vorteilhaften Ausführungsform der vorliegenden Erfindung ist vorgesehen, dass das Optimierungsmodul dazu ausgebildet ist, das Anlagenlayout basierend auf dem Ergebnis des Systemtests und basierend auf den generierten Kenngrößen zu optimieren, ferner basierend auf:
i) einem Vergleich einer Vielzahl von unterschiedlichen Aufbauformen von unterschiedlichen Anlagenlayouts; und/oder
ii) einer quantitativen Ermittlung einer Über- und/oder Unter-Dimensionierung der Verkabelung des bereitgestellten Anlagenlayouts; und/oder
iii) einer quantitativen Ermittlung der Verlustleistungen und des Wirkungsgrads der Verkabelung des bereitgestellten Anlagenlayouts.

In einer vorteilhaften Ausführungsform der vorliegenden Erfindung ist vorgesehen, dass das Optimierungsmodul dazu ausgebildet ist, dass eine dem Anlagenlayout zugeordnete Bewertung der Last- und Energieverteilung des Automatisierungssystems basierend auf den generierten Kenngrößen für die zugeordnete Last- und Energieverteilung des Automatisierungssystems und auf dem Anlagenlayout bereitgestellt wird.

Die dem Anlagenlayout zugeordnete Bewertung kann einen Bewertungsparameter umfassen, dessen Nennwert einer Schutz-Niveau-Stufe oder eine Gefahrenanalyse wiederspiegelt.

In einer vorteilhaften Ausführungsform der vorliegenden Erfindung ist vorgesehen, dass die Verkabelung definiert ist durch Daten zu
i) Kabellängen; und/oder
ii) Leiterquerschnitten; und/oder
iii) einer Knotenstruktur; und/oder
iv) einer Verlustleistung; und/oder
v) einem Wirkungsgrad
eines Kabelnetzwerkes des elektrischen Automatisierungssystems.

In einer vorteilhaften Ausführungsform der vorliegenden Erfindung ist vorgesehen, dass der Systemtest für das bereitgestellte Anlagenlayout des Automatisierungssystems den Einfluss von Störungen wie
i) Spannungseinbruch; und/oder
ii) Lastwechsel; und/oder
iii) Ausfall einer Energieversorgung; und/oder
iv) Kurzschluss der Verkabelung; und/oder
v) Leitungsunterbrechung der Verkabelung
umfasst.

In einer vorteilhaften Ausführungsform der vorliegenden Erfindung ist vorgesehen, dass die Kenngrößen für die zugeordnete Last- und Energieverteilung des Automatisierungssystems
i) einen Wirkungsgrad einer elektrischen Komponente des Automatisierungssystems; und/oder
ii) eine Verlustleistung einer Leitung der Verkabelung des Automatisierungssystems; und/oder
iii) einen Materialanteil einer Leitung der Verkabelung des Automatisierungssystems; und/oder
iv) eine Materialmenge einer Leitung der Verkabelung des Automatisierungssystems; und/oder
v) eine Gewichtslast einer Leitung der Verkabelung des Automatisierungssystems
umfasst.

In einem dritten Aspekt der vorliegenden Erfindung ist ein Rechnernetzsystem vorgesehen, umfassend die Vorrichtung zur Anlagenauslegung eines elektrischen Automatisierungssystems gemäß dem zweiten Aspekt der vorliegenden Erfindung.

In einem vierten Aspekt der vorliegenden Erfindung ist ein Computerprogramm oder Computerprogrammprodukt vorgesehen, umfassend Befehle, die bei der Ausführung des Programms durch einen Computer diesen veranlassen, die Schritte des Verfahrens zur Anlagenauslegung eines elektrischen Automatisierungssystems gemäß dem ersten Aspekt der vorliegenden Erfindung auszuführen.

In einem fünften Aspekt der vorliegenden Erfindung ist ein Computerlesbares (Speicher)medium vorgesehen, umfassend Befehle, die bei der Ausführung durch einen Computer diesen veranlassen, die Schritte des Verfahrens zur Anlagenauslegung eines elektrischen Automatisierungssystems gemäß dem ersten Aspekt der vorliegenden Erfindung auszuführen.

Die beschriebenen Ausgestaltungen und Weiterbildungen lassen sich beliebig miteinander kombinieren.

Weitere mögliche Ausgestaltungen, Weiterbildungen und Implementierungen der vorliegenden Erfindung umfassen auch nicht explizit genannte Kombinationen von zuvor oder im Folgenden bezüglich der Ausführungsformen beschriebenen Merkmale der vorliegenden Erfindung.

Die beiliegenden Zeichnungen sollen ein weiteres Verständnis der Ausführungsformen der vorliegenden Erfindung vermitteln.

Die beiliegenden Zeichnungen veranschaulichen Ausführungsformen und dienen im Zusammenhang mit der Beschreibung der Erklärung von Konzepten der vorliegenden Erfindung.

Andere Ausführungsformen und viele der genannten Vorteile ergeben sich im Hinblick auf die Figuren der Zeichnungen. Die dargestellten Elemente der Figuren der Zeichnungen sind nicht notwendigerweise maßstabsgetreu zueinander gezeigt.

### Kurze Beschreibung der Figuren

Es zeigen:
- Fig. 1:: eine schematische Darstellung einer Vorrichtung zur Anlagenauslegung eines elektrischen Automatisierungssystems gemäß einem Ausführungsbeispiel der vorliegenden Erfindung; und
- Fig. 2:: eine schematische Darstellung eines Flussdiagramms eines Verfahrens zur Anlagenauslegung eines elektrischen Automatisierungssystems gemäß einem Ausführungsbeispiel der vorliegenden Erfindung; und

### Detaillierte Beschreibung der Ausführungsbeispiele

In den Figuren der Zeichnungen bezeichnen gleiche Bezugszeichen gleiche oder funktionsgleiche Elemente, Bauteile, Komponenten oder Verfahrensschritte, soweit nichts Gegenteiliges angegeben ist.

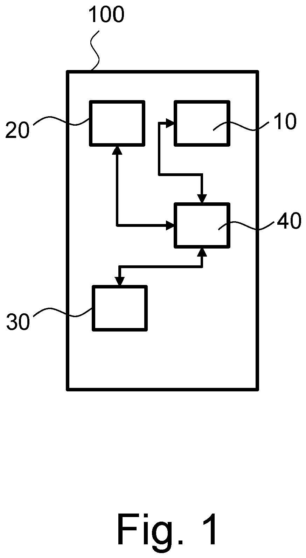

Die Fig. 1 zeigt eine schematische Darstellung einer Vorrichtung zur Anlagenauslegung eines elektrischen Automatisierungssystems gemäß einem Ausführungsbeispiel der vorliegenden Erfindung.

Die Vorrichtung 100 umfasst ein Konfigurationsmodule 10, ein Kenngrößenmodul 20, und ein Systemtestmodul 30 und ein Optimierungsmodul 40.

Das Konfigurationsmodul 10 ist dazu ausgebildet, ein Anlagenlayout des Automatisierungssystems mit einer zugeordneten Last- und Energieverteilung für eine Verkabelung des Automatisierungssystems bereitzustellen.

Dabei kann die Verkabelung des Automatisierungssystems definiert sein durch Daten zu den Kabellängen der einzelnen Leitungen, wie sie in ihrer Gesamtheit die Verkabelung bilden.

Ferner können Daten zu den Leiterquerschnitten der einzelnen Leitungen der Verkabelung abgespeichert werden, um das Anlagenlayout zu definieren.

Ferner können Daten zu einer Knotenstruktur eines Teilbereichs oder der Gesamtheit der Verkabelung abgespeichert werden, um das Anlagenlayout zu charakterisieren.

Ferner können Daten zu einer Verlustleistung und/oder einem Wirkungsgrad der Verkabelung eines Kabelnetzwerkes des elektrischen Automatisierungssystems abgespeichert werden.

Das Kenngrößenmodul 20 ist dazu ausgebildet, Kenngrößen für die zugeordnete Last- und Energieverteilung des Automatisierungssystems zu generieren.

Die Last- und Energieverteilung des Automatisierungssystems kann dabei durch eine Benutzereingabe vorgegeben sein oder durch ein Abrufen von Systemanforderungen aus einer mit der Vorrichtung gekoppelten Datenbank definiert werden.

Das Systemtestmodul 30 ist dazu ausgebildet, einen Systemtest für das bereitgestellte Anlagenlayout des Automatisierungssystems basierend auf den generierten Kenngrößen durchzuführen.

Das Optimierungsmodul 40 ist dazu ausgebildet, das Anlagenlayout basierend auf einem Ergebnis des Systemtests und basierend auf den generierten Kenngrößen zu optimieren.

In einer vorteilhaften Ausführungsform der vorliegenden Erfindung ist vorgesehen, dass die Kenngrößen für die zugeordnete Last- und Energieverteilung des Automatisierungssystems einen Wirkungsgrad einer oder mehrerer oder aller elektrischen Komponenten des Automatisierungssystems umfassen.

In einer vorteilhaften Ausführungsform der vorliegenden Erfindung ist vorgesehen, dass die Kenngrößen für die zugeordnete Last- und Energieverteilung des Automatisierungssystems eine Verlustleistung einer oder mehrerer oder aller Leitungen der Verkabelung des Automatisierungssystems umfassen.

Beispielsweise kann ein Automatisierungssystem M Leitungen umfassen. Die Optimierung kann dabei auf N Leitungen beschränkt werden, wobei N eine Ganzzahl zwischen 1 und M ist.

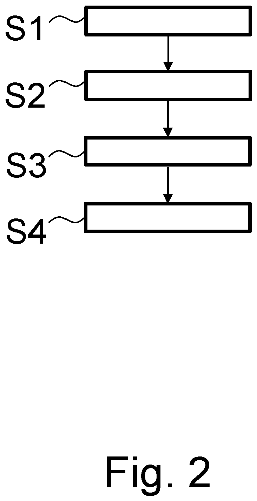

Die Fig. 2 eine schematische Darstellung eines Flussdiagramms eines Verfahrens zur Anlagenauslegung eines elektrischen Automatisierungssystems gemäß einem Ausführungsbeispiel der vorliegenden Erfindung.

Als ein erster Verfahrensschritt erfolgt ein Bereitstellen S1 eines Anlagenlayouts des Automatisierungssystems mit einer zugeordneten Last- und Energieverteilung für eine Verkabelung des Automatisierungssystems.

Als ein zweiter Verfahrensschritt erfolgt ein Generieren S2 von Kenngrößen für die zugeordnete Last- und Energieverteilung des Automatisierungssystems.

Als ein dritter Verfahrensschritt erfolgt ein Durchführen S3 eines Systemtestes für das bereitgestellte Anlagenlayout des Automatisierungssystems basierend auf den generierten Kenngrößen.

Als ein vierter Verfahrensschritt erfolgt ein Optimieren S4 des Anlagenlayouts basierend auf einem Ergebnis des Systemtests und basierend auf den generierten Kenngrößen.

Die Verfahrensschritte des Verfahrens zur Anlagenauslegung eines elektrischen Automatisierungssystems können iterative abgearbeitet werden.

Das Verfahren zur Anlagenauslegung eines elektrischen Automatisierungssystems gemäß einem Ausführungsbeispiel der vorliegenden Erfindung kann dabei visuell das Anlagenlayout darstellen.

Dabei werden die Verbindungen zwischen Einspeisungen, Knoten und Funktionskomponenten sowie den Lasten, beispielsweise bei AC 400V-Netzen in der Regel Motoren auf den gegebenen Kabelwegen simuliert und dargestellt.

Das Programm ermittelt beispielsweise aus der Linienlänge auf einem maßstäblichen Bild des Anlagenlayouts des elektrischen Automatisierungssystems die ungefähren Längen der Kabel der Verkabelung. Mit der Simulation können die Kabellängen variiert werden und gegebenenfalls kritische Grenzlängen ermittelt werden.

Die Integrität der Verteilung bzw. des Anlagenlayouts ist beispielsweise gewährleistet, wenn vorhersehbare Störungen wie Spannungseinbrüche, Lastwechsel, oder Ausfall einer DC-Stromversorgung oder von mehreren DC-Stromversorgungen, oder von sonstigen Komponenten die Stabilität der Versorgung bzw. des Anlagenlayouts des elektrischen Automatisierungssystems nicht gefährden.

Dazu können diese Störungen im Programm bzw. im Verfahren der vorliegenden Erfindung gezielt erzeugt werden, und somit werden die entsprechenden Auswirkungen in der Simulation sichtbar.

Das Programm bzw. das Verfahren der vorliegenden Erfindung ermittelt beispielsweise als Vergleichsgrößen etwa ein Wirkungsgrad, eine Verlustleistung der Verteilung, eine Kabelverlustleistung, Stromwärme im Betrieb, die verbaute Kupfer-Menge der Verkabelung, die verbaute Brandlast der Verkabelung, die zu verlegende Kabellänge der Verkabelung, die Gewichtslast auf Kabelpritschen des elektrischen Automatisierungssystems. Die Vergleichsgrößen können für ein Kabel oder mehrere Kabel der Verkabelung berechnet werden.

Diese Vergleichsgrößen werden beispielsweise für jedes Anlagenlayout berechnet und die jeweilig berechneten Vergleichsgrößen können für unterschiedliche unterschiedlichen Aufbauformen verglichen werden. Mit der Simulation können die Reserven oder Überlastungszonen der Energie- und Lastverteilungen des Anlagenlayouts des elektrischen Automatisierungssystems ermittelt und aneinander angeglichen werden.

Obwohl die vorliegende Erfindung anhand bevorzugter Ausführungsbeispiele vorstehend beschrieben wurde, ist sie nicht darauf beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Ergänzend sei darauf hingewiesen, dass "umfassend" und "aufweisend" keine anderen Elemente oder Schritte ausschließt und "eine" oder "ein" keine Vielzahl ausschließt.

Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zur Anlagenauslegung eines elektrischen Automatisierungssystems, wobei das Verfahren folgende Verfahrensschritte aufweist:
- Bereitstellen (S1) eines Anlagenlayouts des Automatisierungssystems mit einer zugeordneten Last- und Energieverteilung für eine Verkabelung des Automatisierungssystems;
- Generieren (S2) von Kenngrößen für die zugeordnete Last- und Energieverteilung des Automatisierungssystems;
- Durchführen (S3) eines Systemtestes für das bereitgestellte Anlagenlayout des Automatisierungssystems basierend auf den generierten Kenngrößen; und
- Optimieren (S4) des Anlagenlayouts basierend auf einem Ergebnis des Systemtests und basierend auf den generierten Kenngrößen.

2. Verfahren nach Patentanspruch 1, wobei der Systemtest für das bereitgestellte Anlagenlayout des Automatisierungssystems eine Variation von
i) Parametern des elektrischen Automatisierungssystems; und/oder
ii) den generierten Kenngrößen
umfasst.

3. Verfahren nach Patentanspruch 1 oder 2, wobei das Optimieren (S4) des Anlagenlayouts basierend auf dem Ergebnis des Systemtests und basierend auf den generierten Kenngrößen umfasst:
i) ein Optimieren basierend auf einem Vergleich einer Vielzahl von unterschiedlichen Aufbauformen von unterschiedlichen Anlagenlayouts; und/oder
ii) ein Optimieren basierend auf einer quantitativen Ermittlung einer Über- und/oder Unter-Dimensionierung der Verkabelung des bereitgestellten Anlagenlayouts; und/oder
iii) ein Optimieren basierend auf einer quantitativen Ermittlung von Verlustleistungen und/oder eines Wirkungsgrads der Verkabelung des bereitgestellten Anlagenlayouts.

4. Verfahren nach einem der vorhergehenden Patentansprüche, wobei basierend auf den generierten Kenngrößen für die zugeordnete Last- und Energieverteilung des Automatisierungssystems und auf dem Anlagenlayout eine dem Anlagenlayout zugeordnete Bewertung der Last- und Energieverteilung des Automatisierungssystems bereitgestellt wird.

5. Verfahren nach einem der vorhergehenden Patentansprüche, wobei die Verkabelung definiert wird durch Daten zu:
i) Kabellängen von einem oder mehreren oder aller Kabel der Verkabelung; und/oder
ii) Leiterquerschnitte von einem oder mehreren oder aller Kabel der Verkabelung; und/oder
iii) einer Knotenstruktur von mehreren oder aller Kabel der Verkabelung; und/oder
iv) einer Verlustleistung eines anteiligen Kabels der Verkabelung; und/oder
v) einem Wirkungsgrad eines anteiligen Kabels der Verkabelung; und/oder
vi) einer Verlustleistung von mehreren oder aller Kabel der Verkabelung; und/oder
vii) einem Wirkungsgrad von mehreren oder aller Kabel der Verkabelung;
eines Kabelnetzwerkes des elektrischen Automatisierungssystems.

6. Verfahren nach einem der vorhergehenden Patentansprüche, wobei der Systemtest für das bereitgestellte Anlagenlayout des Automatisierungssystems den Einfluss von Störungen wie
i) Spannungseinbruch; und/oder
ii) Lastwechsel; und/oder
iii) Ausfall einer Energieversorgung; und/oder
iv) Kurzschluss der Verkabelung; und/oder
v) Leitungsunterbrechung der Verkabelung
umfasst.

7. Verfahren nach einem der vorhergehenden Patentansprüche, wobei die Kenngrößen für die zugeordnete Last- und Energieverteilung des Automatisierungssystems
i) einen Wirkungsgrad einer oder mehrerer oder aller elektrischen Komponenten des Automatisierungssystems; und/oder
ii) eine Verlustleistung einer oder mehrerer oder aller Leitungen der Verkabelung des Automatisierungssystems; und/oder
iii) einen Materialanteil einer oder mehrerer oder aller Leitungen der Verkabelung des Automatisierungssystems; und/oder
iv) eine Materialmenge einer oder mehrerer oder aller Leitungen der Verkabelung des Automatisierungssystems; und/oder
v) eine Gewichtslast einer oder mehrerer oder aller Leitungen der Verkabelung des Automatisierungssystems; und/oder
vi) eine Brandlast einer oder mehrerer oder aller Leitungen der Verkabelung des Automatisierungssystems
umfasst.

8. Verfahren nach einem der vorhergehenden Patentansprüche, wobei das Optimieren (S4) des Anlagenlayouts basierend auf dem Ergebnis des Systemtests und den generierten Kenngrößen eine Berechnung von Leistungsreserven und/oder Überlastungszonen des Anlagenlayouts umfasst.

9. Vorrichtung (100) zur Anlagenauslegung eines elektrischen Automatisierungssystems, wobei die Vorrichtung (100) umfasst:
- ein Konfigurationsmodul (10), welches dazu ausgebildet ist, ein Anlagenlayout des Automatisierungssystems mit einer zugeordneten Last- und Energieverteilung für eine Verkabelung des Automatisierungssystems bereitzustellen;
- ein Kenngrößenmodul (20), welches dazu ausgebildet ist, Kenngrößen für die zugeordnete Last- und Energieverteilung des Automatisierungssystems zu generieren;
- ein Systemtestmodul (30), welches dazu ausgebildet ist, einen Systemtest für das bereitgestellte Anlagenlayout des Automatisierungssystems basierend auf den generierten Kenngrößen durchzuführen; und
- ein Optimierungsmodul (40), welches dazu ausgebildet ist, das Anlagenlayout basierend auf einem Ergebnis des Systemtests und basierend auf den generierten Kenngrößen zu optimieren.

10. Vorrichtung nach Patentanspruch 9, wobei der Systemtest für das bereitgestellte Anlagenlayout des Automatisierungssystems eine Variation von
i) Parametern des elektrischen Automatisierungssystems; und/oder
ii) den generierten Kenngrößen
umfasst.

11. Vorrichtung nach Patentanspruch 9 oder 10, wobei das Optimierungsmodul (40) dazu ausgebildet ist, das Anlagenlayout basierend auf dem Ergebnis des Systemtests und den generierten Kenngrößen zu optimieren, basierend auf:
i) einem Vergleich einer Vielzahl von unterschiedlichen Aufbauformen von unterschiedlichen Anlagenlayouts; und/oder
ii) einer quantitativen Ermittlung einer Über- und/oder Unter-Dimensionierung der Verkabelung des bereitgestellten Anlagenlayouts; und/oder
iii) einer quantitativen Ermittlung der Verlustleistungen und des Wirkungsgrads der Verkabelung des bereitgestellten Anlagenlayouts.

12. Vorrichtung nach einem der vorhergehenden Patentansprüche 9 bis 11,
wobei das Optimierungsmodul (40) dazu ausgebildet ist, dass eine dem Anlagenlayout zugeordnete Bewertung der Last- und Energieverteilung des Automatisierungssystems basierend auf den generierten Kenngrößen für die zugeordnete Last- und Energieverteilung des Automatisierungssystems und auf dem Anlagenlayout bereitgestellt wird.

13. Vorrichtung nach einem der vorhergehenden Patentansprüche 9 bis 12,
wobei die Verkabelung definiert ist durch Daten zu
i) Kabellängen von einem oder mehreren oder aller Kabel der Verkabelung; und/oder
ii) Leiterquerschnitten von einem oder mehreren oder aller Kabel der Verkabelung; und/oder
iii) einer Knotenstruktur von mehreren oder aller Kabel der Verkabelung; und/oder
iv) einer Verlustleistung eines anteiligen Kabels der Verkabelung; und/oder
v) einem Wirkungsgrad eines anteiligen Kabels der Verkabelung; und/oder
vi) einer Verlustleistung von mehreren oder aller Kabel der Verkabelung; und/oder
vii) einem Wirkungsgrad von mehreren oder aller Kabel der Verkabelung;
eines Kabelnetzwerkes des elektrischen Automatisierungssystems.

14. Vorrichtung nach einem der vorhergehenden Patentansprüche 9 bis 13,
wobei der Systemtest für das bereitgestellte Anlagenlayout des Automatisierungssystems den Einfluss von Störungen wie
i) Spannungseinbruch; und/oder
ii) Lastwechsel; und/oder
iii) Ausfall einer Energieversorgung; und/oder
iv) Kurzschluss der Verkabelung; und/oder
v) Leitungsunterbrechung der Verkabelung
umfasst.

15. Vorrichtung nach einem der vorhergehenden Patentansprüche 9 bis 14,
wobei die Kenngrößen für die zugeordnete Last- und Energieverteilung des Automatisierungssystems
i) einen Wirkungsgrad einer oder mehrerer oder aller elektrischen Komponenten des Automatisierungssystems; und/oder
ii) eine Verlustleistung einer oder mehrerer oder aller Leitungen der Verkabelung des Automatisierungssystems; und/oder
iii) einen Materialanteil einer oder mehrerer oder aller Leitungen der Verkabelung des Automatisierungssystems; und/oder
iv) eine Materialmenge einer oder mehrerer oder aller Leitungen der Verkabelung des Automatisierungssystems; und/oder
v) eine Gewichtslast einer oder mehrerer oder aller Leitungen der Verkabelung des Automatisierungssystems; und/oder
vi) eine Brandlast einer oder mehrerer oder aller Leitungen der Verkabelung des Automatisierungssystems
umfasst.
